(19) Europäisches Patentamt
European Patent Office
Office européen des brevets

(11) **EP 1 478 796 B1**

(12) **EUROPEAN PATENT SPECIFICATION**

(45) Date of publication and mention
of the grant of the patent:
**16.05.2007 Bulletin 2007/20**

(51) Int Cl.:
*D03D 15/00* (2006.01)

(21) Application number: **03704867.5**

(86) International application number:
**PCT/IB2003/000741**

(22) Date of filing: **27.02.2003**

(87) International publication number:
**WO 2003/072861 (04.09.2003 Gazette 2003/36)**

(54) **FABRIC WOVEN WITH FLAT GLASS FIBERS AND PRODUCTION METHOD**

GEWEBE MIT FLACHEN GLASFASERN UND HERSTELLUNGSVERFAHREN

TEXTILE TISSE AVEC DES FIBRES DE VERRE ET PROCEDE DE PRODUCTION

(84) Designated Contracting States:
**AT BE BG CH CY CZ DE DK EE ES FI FR GB GR HU IE IT LI LU MC NL PT SE SI SK TR**

(30) Priority: **28.02.2002 JP 2002054470**

(43) Date of publication of application:
**24.11.2004 Bulletin 2004/48**

(73) Proprietor: **Isola Fabrics s.r.l.**
**20047 Brugherio (IT)**

(72) Inventors:
• **KOBUE, Kazushi**
**Sakura Shimo Aza Ipponsugi 20 960-8670 (JP)**
• **SAKAI, Tomofumi**
**Sakura Shimo Aza Ipponsugi 20 960-8670 (JP)**
• **SUZUKI, Yoshiharu**
**Sakura Shimo Aza Ipponsugi 20 960-8670 (JP)**
• **SCARI', Diego**
**I-20047 Brugherio (IT)**
• **SCARI, Marco**
**20047 Brugherio (IT)**

(74) Representative: **Minoja, Fabrizio**
**Bianchetti Bracco Minoja S.r.l.**
**Via Plinio, 63**
**20129 Milano (IT)**

(56) References cited:
EP-A- 1 001 063          EP-A- 1 039 004
EP-A- 1 176 239          US-A- 4 759 784
US-A- 5 792 713

**Description**

**Field of the invention**

The present invention relates to a woven glass fabric and to production methods of a woven glass fabric obtained by weaving warp yarns and weft yarns.

**Background of the invention**

Thanks to the rapid developments that have occurred lately in the electronic industry, the printed circuits, that constitute the support on which integrated circuits and semiconductors are mounted, undergo continuous improvements. At the base of the printed circuit, the reinforcement material used for electrical insulation is impregnated with a resin and then left to harden. As reinforcement material, a woven glass fabric is generally chosen with a plain weave construction formed by a weft and a warp made of continuous glass fibers.

With the improvements in the impregnation capabilities of the resins, it has become necessary to implement research efforts in the direction of a greater homogeneity of distribution of the fibers in the woven glass fabric used for the printed circuits. Hence, the best distribution of the spaces between the yarns of the woven fabric is obtained utilizing methods aimed at the uniform redistribution of fibers, such as the treatment with sprays of jets of fluid, or the vibration of a fluid, or moreover with direct pressure. In other words, the goal is to fill the spaces and interstices resulting from the weaving process of the woven fabric to render uniform the woven fabric made of weft and warp yarns, since the yarns may tend to separate during the process.

Up to today, in the known woven glass fabrics the following problems are found: with the introduction of terminals of reduced dimensions, more mobile, and the orientation towards high performance materials, an increasing need for thin glass fabrics has emerged, but in which the interstices are however accurately filled. In the case of thin glass fiber fabrics, executing the uniform redistribution of the fibers with jets of fluid or the vibration of a fluid, the fibers tend to separate and break, and moreover the mesh of the fabric is distorted. Trying to limit said problem of separation of the yarns, it is not possible to reach the goal of uniform redistribution of fibers, and therefore filling the interstices becomes problematic.

In the attempt to obtain thin printed circuits, their rigidity is diminished. Therefore, there is the need to obtain a thinner glass fiber fabric, and at the same time to increase the rigidity of the printed circuits that use woven glass fibers fabric.

US 5 792 713 A discloses a glass fabric reinforcement for paper or resinous articles produced with zero-twist yarns having a circular cross section, and a process for the manufacture thereof.

EP 1 039 004 A discloses a non woven fabric made of a highly flat fiber.

The present invention has the goal to provide a production method for a woven glass fiber fabric, in which the phenomenon of surface hairiness does not arise, in which the interstices of the fabric can be filled in a satisfactory way, and with which it is possible to obtain printed circuits with a high rigidity; moreover, the goal of the invention is to provide said woven glass fiber fabric, as well as prepreg and printed circuits.

**Description of the invention**

In order to obtain the goals listed above, the invention provides a production method for a woven glass fabric made up of warp yarns and weft yarns composed of multiple filaments as claimed in claim 1. Said production method being characterized:

- By a phase in which the fused glass is spun, conferring to said filaments a flattened profile;
- By a phase in which said glass filaments are assembled so as to form a yarn of continuous glass fibers;
- By a phase in which said yarn of continuous glass fibers is wound in a way to form a forming cake;
- By a phase in which said yarn of continuous glass fibers is used to weave the glass fabric object of the invention, without having to resort to the process of twisting or rewinding of said continuous glass fibers yarn previously wound on said forming cake.

Up to now, in the production methods used to make woven glass fabrics, the glass filaments, after having been assembled with an appropriate size so as to form a yarn of continuous fibers, are wound onto a forming cake using a winder. Subsequently, the continuous glass fiber yarn, wound on a forming cake, is rewound on a bobbin and finally used for the production of glass fabrics. Moreover, a process of twisting the continuous glass fibers is generally coupled to the process of rewinding through a winder onto a bobbin.

On the contrary, in the glass fabric production method of the current invention, after the continuous glass fibers have been wound onto a forming cake, these are used in the weaving operation of the glass fiber fabric without having to go through the rewinding process beforehand. Therefore, being able to avoid the rewinding process, in which case the continuous glass fibers are not further twisted, it is then possible to limit the phenomenon of surface hairiness. In the case in which the profile of the glass filament is flattened, since its outer surface is more extensive than a filament with a round profile, the surface hairiness due to the friction between the glass filaments themselves tends to take place more easily. Consequently, the possibility to avoid the rewinding process allows a remarkable limitation of the phenomenon of surface hairiness. Moreover, since the continuous glass fibers are not twisted, the packing strength of the filaments is weaker, and therefore, even without proceeding to an operation of uniform redistribution of the fibers, these separate naturally, resulting in a woven fabric with a high degree of filling of the spaces. Moreover, since the glass filament has a flattened profile, the thickness of the part in which filaments overlap one another is thinner with respect to what happens in the case of filaments with a round profile; consequently, the dimensions of the interstices between filaments inside of the woven fabric are reduced. Therefore, if we compare a glass fiber fabric in which a round profile filament has been used, to another in which a flattened profile filament has been used, assuming that they have the same thickness, the second will provide a greater degree of distribution of the fibers. Consequently, the printed circuits made with glass fiber fabrics obtained according to the method of the present invention have greater rigidity.

Moreover, in relation to the manufacturing method object of the present invention, when a yarn formed by glass fibers with a flattened profile is used only in the weft or only in the warp, it will be characterized by continuous fibers that have not undergone a rewinding process.

In the case in which continuous glass fibers of a flattened profile, that do not need a rewinding process, are only used in the weft or only in the warp, the glass fiber fabric does not exhibit surface hairiness problems and it appears as a close-woven fabric, moreover printed circuits with a high degree of rigidity can be obtained.

According to the method of production of the glass fiber fabric pertaining to the present invention, the weaving process of the glass fiber fabric is performed without passing through the process of twisting of continuous glass fibers after their winding onto a forming cake. Avoiding in this way the twisting operation of the continuous glass fibers, it is possible to limit the surface hairiness due to the twisting of the continuous glass fibers. In the case in which the profile of the glass filament is flattened, since its surface is more extensive than the one of a filament with a round profile, the surface hairiness due to friction between the glass filaments themselves tends to take place more easily, consequently the possibility to avoid the rewinding process helps remarkably to limit the phenomenon of surface hairiness. Moreover, since the continuous glass fibers are not twisted, the compaction force of the filaments is weaker, therefore even without proceeding to an operation to uniformly redistribute the fibers, these naturally separate during the weaving process, allowing to obtain a good degree of filling of the interstitial spaces. Moreover, since the glass filament has a flattened profile, the thickness of the side where filaments overlap one another, on the shorter side of the profile, is thinner compared to the case of a filament with a round profile; consequently, the dimensions of the interstices between filaments inside of the fabric are reduced. Therefore, if we compare a glass fiber fabric in which a filament with a round profile has been used to one in which a filament with a flattened profile has been used, assuming that they have the same thickness, the latter will possess a greater degree of distribution of the fibers. Consequently, the printed circuits manufactured with a glass fiber fabric obtained according to the method of the present invention possess greater rigidity.

The method of production of the glass fiber fabric pertaining to the present invention is considered appropriate in case the weft or the warp have glass filaments with a flattened cross-section, and in case the continuous glass fibers have not undergone a twisting process.

In the case in which continuous glass fibers with a flattened profile that do not need a rewinding process are used only in the weft yam or only in the warp yarn, the glass fiber fabric does not exhibit problems of surface hairiness, and a satisfactory degree of filling of the interstitial spaces is obtained, moreover printed circuits are obtained with a high degree of rigidity.

The method of production of the prepreg of the present invention is characterized by the following procedure: a glass fiber fabric obtained following any of the methods of production presented above, is impregnated in a thermosetting resin and is brought to a semi-rigid state.

According to the method of production of the prepreg pertaining to the present invention, using the methods of production presented above, surface hairiness is not found in the continuous glass fibers dipped in the thermosetting resin, the distribution of the fibers is nearly completely uniform, moreover the printed circuits using such prepreg possess comparatively greater rigidity.

The glass fiber fabric of the present invention is a glass fabric composed by a weft and a warp each containing multiple filaments, in which the yarns of at least one of the two components, weft or warp, do not undergo a twisting process, and in which the profile of the filament is given a flattened shape.

In the case of the fabric of the present invention, since the yarn of at least one of the two components, weft or warp, has not undergone a twisting process, allowing in such a way a softer compaction of the fibers, the uniform distribution of the fibers happens naturally, also without proceeding to specific redistribution operation, and a closer-woven fabric is obtained. Moreover, since the yam of at least one of the two components, weft or warp, has not undergone a twisting process, the problem of the surface hairiness due to the twisting process is limited. In the case in which the profile of the glass filament is flattened, being its surface more extensive than that of a round filament, the surface hairiness due to the friction between glass filaments happens more easily. The fact that the surface hairiness is limited is undoubtedly an advantage. Moreover, since the glass filament has a flattened profile, the thickness of the side in which filaments overlap one another, on the shorter side of the profile, is thinner than what happens in the case of a filament with a round profile; consequently the dimensions of the interstices between filaments inside the fabric are reduced. Therefore, if we compare a glass fiber fabric, in which a filament with a round profile has been used to another in which a filament with a flattened profile has been used, assuming that they have the same thickness, the latter will have a greater degree of distribution of the fibers. This is the reason why a printed circuit produced with the glass fiber fabric described in the present invention exhibits a comparatively greater rigidity.

In the case of the glass fiber fabric of the present invention it is considered adequate that the warp yarn has been twisted and has a summarily round profile, whereas the weft yarn has not been twisted and has a flattened profile.

Since the yarn of at least one of the two components of the fabric, weft or warp, has not undergone a twisting process, the compaction of the fibers is softer, and even without proceeding to a specific fiber redistribution operation, the uniform distribution of fibers happens naturally, allowing to obtain a very close-woven fabric. Moreover, if only the weft yarn is not twisted, the surface hairiness of weft yarn due to twisting can be limited.

The prepreg of the present invention is obtained from said woven glass fiber fabric, which is impregnated by a thermosetting resin. In the prepreg of the present invention, since said fabric is used, the weft yarn inside the thermosetting resin does not exhibit surface hairiness and a nearly regular distribution of the fibers is obtained. It follows that the rigidity of the printed circuits produced with such prepregs is comparatively greater. Such results are even more evident if the weft yarn has not been twisted and if a prepreg is employed in which a filament with flattened section has been used.

The printed circuits of the present invention include the above mentioned glass fiber fabrics as base material. In the case of the printed circuits object of the present invention, since said fabrics are used, the weft yarn does not exhibit surface hairiness, the distribution of the fibers is nearly uniform and the rigidity is comparatively higher.

## Detailed description of the invention

The invention will now be described in detail, in an exemplifying way, with reference to the attached Figures, in which it must be noted that the same numbers correspond to the same elements.

- Figure 1 is a schematic diagram of the structure of the glass fiber production system used to produce continuous glass fibers;
- Figure 2 represents the cross-sectional view, as seen from the bottom, of the bushing employed in the glass fiber production system of Figure 1;
- Figure 3 illustrates an automatic loom;
- Figure 4 represents a practical application of the glass fabric object of the present invention;
- Figure 5 represents section VV of the glass fabric of Figure 4;
- Figure 6 is a cross-sectional view of a practical application of the prepreg of the present invention;
- Figure 7 is a cross-sectional view of a practical application of the printed circuit of the present invention;
- Figure 8 represents the short and the long side of the filament;
- Figure 9 illustrates the rate of distribution of the fibers of the warp and weft yarn.

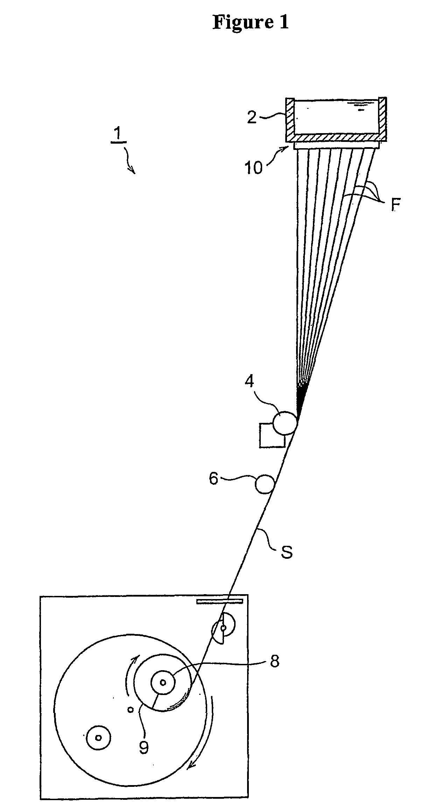

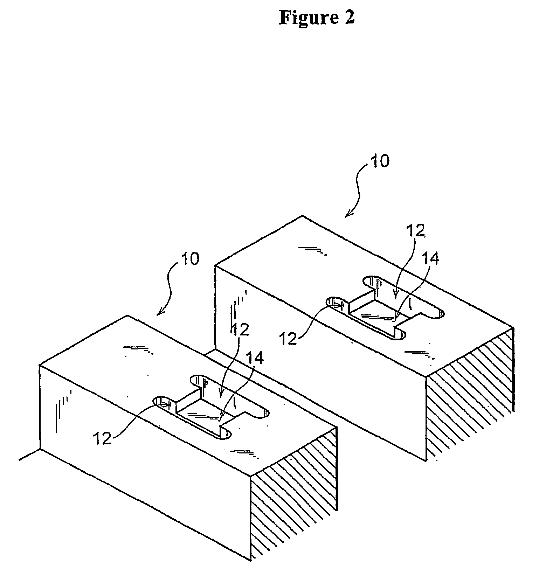

Referring to the Figures from 1 to 3 the method of production of the glass fabric of the present invention will be explained. First of all, we will refer to Figures 1 and 2 in order to explain the production phases starting from the fused glass until the formation of continuous glass fibers. The first Figure represents in abbreviated form the system 1 of production of glass fibers in order to obtain continuous glass fibers. In the system 1 of the production of glass fibers the bushing 10 is positioned at the base, while a crucible 2 is placed in which the fused glass is fed; the fused glass, that comes out from the holes of bushing 10, after having been cooled, becomes the filament F.

Figure 2 is a diagonal view from the bottom side. In the bushing 10, a flattened shape has been given to holes 12 . Moreover, two holes 12 constitute a couple, and between every couple of holes 12 there is a rectangular-shaped socket 14 for the separation of filaments. The fused glass that comes out from each hole 12 is moulded according to the shape of the holes 12, it exhibits a flattened profile and is cooled as it contacts the air present in the unit of separation 14. The fused glass with a flattened profile increases its own viscosity and it solidifies even before decreasing the degree of flattening due to the surface tension, creating in this way the glass filament of flattened profile F.

The production process of glass fibers will be illustrated with reference to Figure 1. Under the bushing 10 a roller 4 is placed to apply the binder. Thanks to said roller 4 used for the binder application, this binder is applied on the glass filament F, which, under the effect of the joining cylinder 6 is assembled and formed in yarn; in this way the continuous glass fiber S is obtained. In a continuous glass fiber S, for example, are contained between 50 and 400 glass filaments F. Subsequently, the yarn is wound in a cylindrical or conical shape with the winder 8, and takes the form of a forming cake 9. But it must be noted that at the state of forming cake 9, the continuous glass fiber has not undergone twisting.

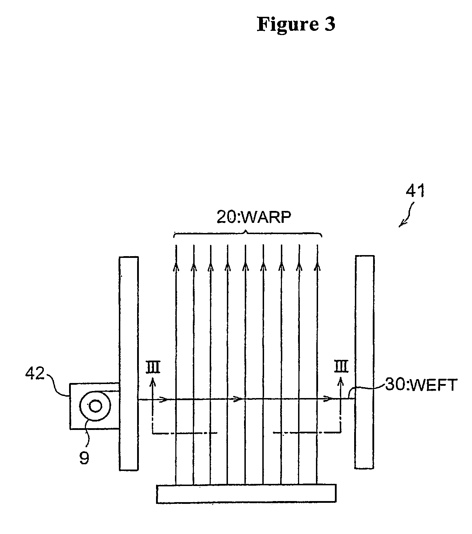

Below we will be examining the automatic loom 41 of Figure 3 and explain the weaving process of the glass fabric. First of all, the forming cake of the continuous glass fibers 9 obtained as explained above, is positioned "as is" in the weft feeder 42. This means that, as far as the weft yarn, the rewinding operation onto a bobbin is not performed as it has been performed up to today. Since the rewinding operation is not performed starting from the forming cake 9, therefore the continuous glass fibers are not twisted. As far as the warp yarn, in the present application the profile of the filament is roughly round and the continuous glass fibers have been rewound from forming cake to bobbin. However as far as warp yarn (not the weft yam), a filament with a flattened profile can be used that has not been rewound from the forming cake.

After having loaded on the automatic loom 41 the weft yarn and warp yarn made of continuous fibers, the loom 41 is started and the multiple yarns of warp yam 20 are inserted in the same direction with a uniform spacing, while the weft yarn 30 is inserted in such a way to cross the warp yam at a 90 degree angle. In this way glass fiber fabric is obtained with a plain weave construction.

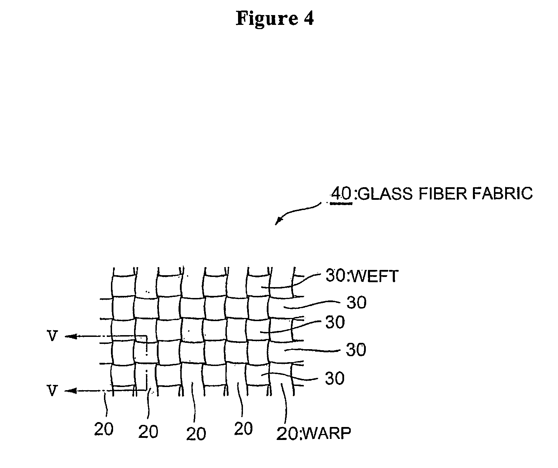

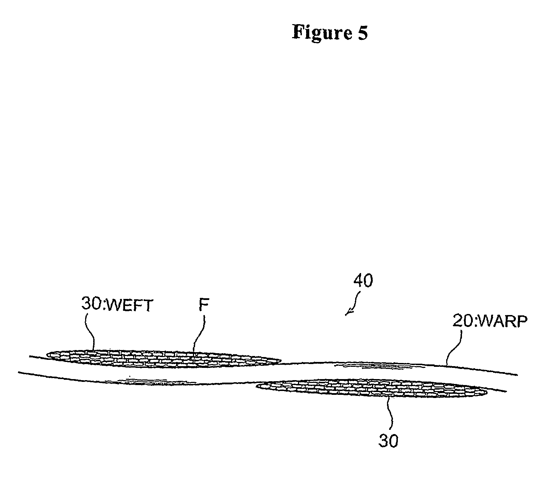

Figure 4 is a depiction of the glass fiber fabric 40 thus obtained, while Figure 5 is the relative cross-section in the VV direction of Figure 4. It is noted that Figure 5 is a cross-section that follows the line that marks half of the width of warp yarn 20 (right-left direction in Figure 4). As it is illustrated in each of the Figures, warp yarn 20 and weft yam 30 cross each other overpassing one another, alternatively.

As described above, as far as the fabrication of the glass fiber fabric 40, the continuous glass fiber S, after having been wound in a cylindrical shape onto forming cake 9, is then woven in the glass fabric 40 without undergoing any rewinding operation onto a bobbin, that is without imposing to the continuous glass fiber S a further twisting process. If the rewinding process of the continuous fibers is avoided (twisting process), and continuous glass fibers S (weft yam 30) do not undergo twisting, it is possible to limit the surface hairiness. Moreover, since the weft yam has not undergone twisting, its degree of compaction is weaker; that allows to obtain a uniform distribution of the fibers in a natural way with the force exercised by the warp yarn 20, without having to perform a specific separate operation with the goal of obtaining a uniform distribution of the fibers. Moreover, even if the filament is not distributed in an uniform way, when the force of the warp yam is exercised, since the secondary moment for the glass fiber filament with a flattened profile is greater and since also the rotation radius is greater, the filament tends to position itself in the direction of the short side, therefore resulting in a thin yam with a wide surface.

Moreover, also in the case in which any treatment for the uniform redistribution of fibers is applied to the glass fibers fabric 40, such as a spray of jets of liquid or the vibration of a liquid, inasmuch as the continuous glass fiber S has not undergone any twisting operation and therefore its degree of compaction is weak, a satisfactory uniform redistribution of the fibers is obtained even if the energy applied to the glass fiber fabric 40 at the moment of the operation of fibers redistribution is smaller. The result is a close-woven glass fiber fabric 40 and at the same time a limited surface hairiness. As examples of energy used during the operation of uniform redistribution of fibers, we can mention the speed or the power of the jet of liquid in the case of a spray operation, or the frequency of vibration in case of a treatment with vibration of a liquid. It is possible to set the speed of such treatments so as to vary the degree of distribution of the fibers.

Being the glass filament F that constitutes the weft yam 30 of flattened profile, at the moment of the weaving process the various glass filaments F are inserted with their length positioned horizontally as evidenced in Figure 5. Moreover, since the profile of the filament F is flattened, the interstices between the contiguous filaments F are of smaller dimensions, that is, the filaments F are closer between themselves. Moreover, the thickness of the glass fabric 40 is thinner in the direction in which the short sides of the section of filaments F are overlapped (top-bottom direction in Figure 5).

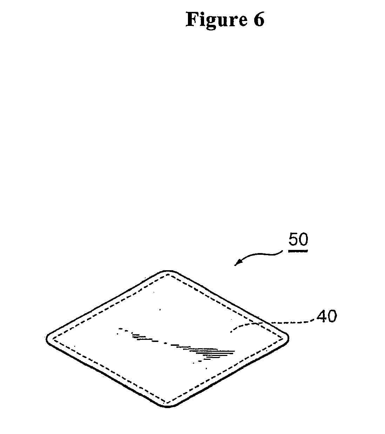

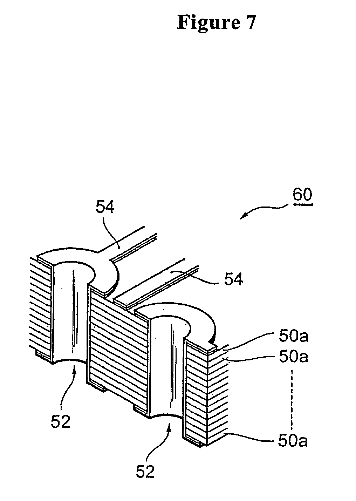

With reference to Figures 6 and 7, explanations are now given about the prepreg and the printed circuits in which the glass fiber fabric 40 is used. Figure 6 is an oblique view of prepreg 50 manufactured with the glass fiber fabric 40 of the present practical application, while Figure 7 represents printed circuit 60 manufactured with prepreg 50 as base material. For prepreg 50, after having impregnated the glass fabric 40 with thermosetting resin that has a resin-matrix function, a drying treatment is applied after which prepreg 50 will be in a semi-rigid state. As far as the resin-matrix, practically epoxy resins, non-saturated polyester resins and polyimide resins and other similar resins are used.

Printed circuit (PWB: Printed Wiring Board) 60 formed with prepreg 50 as base material can be obtained as described below. At first, several prepregs are overlapped on each other and, using pressure and heat, a multilayer laminate is obtained. To the laminate that has undergone a pressure and temperature treatment is attributed 50a. On both sides (or also on a single side) of the multilayer laminate a copper sheet is applied and a copper clad laminate is obtained (CCL: Copper Clad Laminate). Following a method such as the so called "subtractive" method, line 54 is shaped, which constitutes the printed circuit. In this way the printed circuit 60 is completed as it is represented in Figure 7. However, the printed circuits of the present invention are not limited to what is depicted in Figure 7, as a large number of variations are possible. As an example, instead of limiting the printed circuit to the external surface, it can be realized also in the inner layers, thus obtaining multilayer printed circuits (ML-PWB: Multilayer Printed Wiring Board).

Said prepreg 50 comprises the glass fabric 40 impregnated in the thermosetting resin; said glass fabric 40 exhibits weft yam of uniform distribution and without surface hairiness. This is the reason why the printed circuit 60 made with said prepreg 50 is of homogenous rigidity in all points. Moreover, as already explained previously, since the profile of the filament F is flattened, the position of the filaments F inside the prepreg 50 is very close; this confers greater rigidity to printed circuit 60, which takes advantage of the prepreg 50 for its fabrication. Based on such premises, it is possible to obtain a thin printed circuit 60, but with a high degree of rigidity.

In the present practical application, the continuous glass fiber S obtained from the glass fiber filament of flattened profile F that has not undergone the rewinding twisting operation, is not used in the warp yam and in the weft yarn at the same time, but only in the weft yarn. However, also in such circumstances it is possible to limit the surface hairiness at the moment of the uniform redistribution of the fibers and obtain a close-woven fabric in a satisfactory way, and also a printed circuit 60 with high rigidity. However, differently from the present practical application, in which the continuous glass fiber S that has been obtained from the filament F and that has not undergone the rewinding and twisting process is used only in the weft 20, it is anyway possible to use said continuous glass fiber S only in warp 30. Obviously, it is also possible to use the continuous glass fiber S that has been obtained from the filament F that has not undergone the rewinding and twisting process both for warp 20 and for weft 30.

### Examples of practical applications

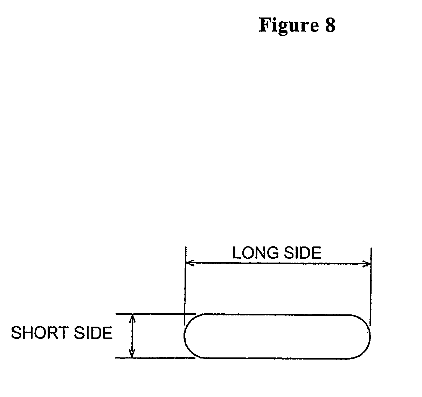

Below, based on practical applications, the results of the present invention will be examined more concretely. As evidenced in Table 1, in the example of practical application 1, the warp yam ECE225 is formed by a round glass filament of 7 $\mu$m diameter, and the weft yam is formed by a glass filament with a flattened profile whose short side is of 4.5 $\mu$m and long side of 18 $\mu$m. The long and short sides express the length depicted in Figure 8. Since the warp yarn has been rewound on bobbin, after having been spun and wound on a forming cake, it possesses a twist of 1.0 turns/25 mm. The weft yam instead, not being rewound, has not undergone any twisting operation. On the glass fabric formed by such weft and warp, no operation has been performed for the uniform redistribution of the fibers.

**Table 1**

| | | | Example of practical application 1 | Comparative example 1 | Comparative example 2 |
|---|---|---|---|---|---|
| Continuo us glass fibers yarns | Filament Diameter ($\mu$m) | Warp | 7 | 7 | 7 |
| | | Weft | Short side 4.5 Long Side 18 (flattened profile) | Short side 4.5 Long Side 18 (flattened profile) | 9 |
| | Yarn Count | Warp | 22.5 | 22.5 | 22.5 |
| | | Weft | 33.7 | 33.7 | 33.7 |
| | Torsion (turns/25 mm) | Warp | 0.7Z | 0.7Z | 0.7Z |
| | | Weft | 0Z (no rewinding) | 1.0Z | 0Z (no rewinding) |
| Density of the fabric (yarns/25 mm) | | Warp | 40 | | |
| | | Weft | 39 | | |
| Air permeability (cm$^3$/cm$^2$/s) | | | 41.1 | 119.6 | 132.9 |
| Unit weight (g/cm$^2$) | | | 88.1 | | |
| Thickness (millimeter) | | | 0.082 | 0.09 | 0.093 |
| Fabric degree of impregnation (%) | | | 41.3 | 37.7 | 36.4 |

Having carried out the measurement of air permeability of this glass fabric in a conforming apparatus (JIS R 3420), a relatively low value of 41.1 cm$^3$/cm$^2$/s is resulted. That means that even if no operation of uniform redistribution of the fibers has been performed, the glass fabric of practical application 1 exhibits a low air permeability and a closed weave. That is because the weft yarn with a flattened profile has not been twisted, because its degree of compaction is low and because the uniform distribution of the fibers has happened in a natural way in the weaving phase. It is noted however that the glass fabric, after having been impregnated in the resin, reaches a degree of impregnation of the glass fibers of 41.3% inside of the hardened multilayer. Moreover, by examination of the surface of the glass fabric, no surface hairiness of the weft yam is found. This is due to the fact that it was possible to avoid the twisting operation.

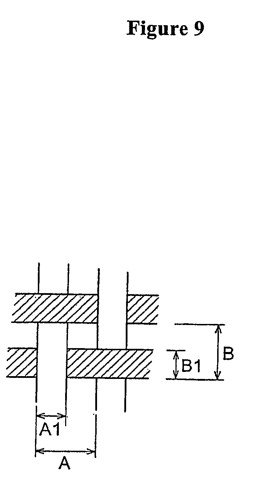

After having measured the degree of air permeability, the treatment of uniform redistribution of the fibers of the glass fabric of the practical application 1 with a liquid (water) was performed. The glass fabric that before the operation of uniform redistribution of the fibers had a degree of distribution of the fibers of the warp yarn of 49.7%, and a degree of distribution of the fibers of the weft yam of 95.9%, with an air permeability of 41.1 cm$^3$/cm$^2$/s, has exhibited a degree of distribution of the fibers of the warp yam of 81.6% and a degree of distribution of the fibers of the weft yarn of 97.6%, with an air permeability of 13.2 cm$^3$/cm$^2$/s. By examination of the surface of the glass fabric after the uniform redistribution of the fibers, almost no sign of surface hairiness has been found. Moreover, these results allow to underline that, in the case of the glass fabric of the current example of practical application, the uniform redistribution of the fibers is obtained more easily for the warp yam than for the weft yarn. The degree of distribution of the fibers of the warp yam and of the weft yarn, with reference to Figure 9, has been calculated in the following way:

$$\text{degree of distribution of the fibers of the warp yarn} = A1/A \times 100 \ (\%)$$

$$\text{degree of distribution of the fibers of the weft yarn} = B1/B \times 100 \ (\%)$$

A = warp yarn spacing
A1 = width of the warp yam
B = weft yam spacing
B1 = width of the weft yarn.

In the glass fabric of comparative example 1, for warp yam and weft yarn the same yam of the example of practical application 1 has been used. The part in which the comparative example diverges from the example of practical application 1 is the following: before weaving, the weft yarn is rewound on a bobbin with a torsion of 1.0 turns/25 mm. As in the example of practical application 1, the measurement of air permeability of this glass fabric has been carried out in a conforming apparatus (JIS R 3420) and the result is 119.6 cm$^3$/cm$^2$/s. This result shows that the glass fabric of comparative example 1, with respect to the one of the example of practical application 1, is less close-woven. This is due to the fact that the weft yarn with a flattened profile has been twisted, the degree of compaction of the fibers is high, and therefore the weft yarn does not widen easily during weaving. Moreover, since in comparative example 1 the rewinding of the weft yam has been performed, we observe a substantial surface hairiness of the weft yarn of the glass fabric.

Differently from the example of practical application 1, for the glass fabric of comparative example 2 a glass filament of round profile (diameter 9 μm) has been used. However, as in the example of practical application 1, the weft yarn has not been rewound from the forming cake to the bobbin and no twisting operation has been performed. As in the example of practical application 1, the measurement of air permeability of said glass fabric has been performed in a conforming apparatus (JIS R 3420) and the result is 132.9 cm$^3$/cm$^2$/s. This result shows that the glass fabric of comparative example 2, with respect to the one of the example of practical application 1, is less close-woven. In this way it is evident that simply not performing the twisting of the weft or warp yarn is not enough to increase the uniform distribution of the fibers. The improvement of the degree of uniform distribution of the fibers is connected to the use of a filament with a flattened profile for the continuous glass fibers, and to the lack of twisting.

**Claims**

1. Method for the preparation of a glass fabric in which the weft and the warp yarns consist of a glass yarn of multiple filaments, comprising the following phases:

   - spinning the fused glass to form glass filaments;
   - assembling said glass filaments in a way as to form a continuous glass fiber weft yarn and warp yarn;
   - winding said yarn of continuous glass fibers as to form a forming cake;

- using said yarns of continuous glass fibers to weave the glass fabric, **characterised in that** at least one of the weft yarn and warp yarn has a flattened section and is woven untwisted and without having to be rewound.

2. Method of claim 1, wherein only the weft yarn or the warp yarn has a flattened section and is woven untwisted and not rewound in making the glass fabric, while the warp yarn or the weft yarn has a roughly round section and has undergone twisting.

3. Method according to claim 1 or 2, in which said fabric is comprised of said warp and said weft, the glass filaments of at least one of which are **characterized by** said flat cross-section, and which fabric is moreover **characterized by** being composed of said continuous glass fibers that do not need a process of further twisting or rewinding.

4. Method for the preparation of a prepreg, **characterized in that** it is formed with a glass fabric obtained according to the methods of anyone of claims 1 to 3, and brought to a semi-rigid state through impregnation in a thermosetting resin bath and subsequent drying.

5. Glass fabric comprising weft and warp yarns consisting of a glass yarn of multiple filaments, **characterised in that** at leat one of the weft yam and warp yarn is a flat, untwisted and not rewound yarn.

6. Glass fabric according to claim 5, wherein the weft yam is a flat, untwisted and not rewound yarn, while the warp yarn is a roughly round, twisted yarn.

7. Prepreg **characterized in that** it is obtained by the impregnation of the glass fabric of claim 5 or 6 in a thermosetting resin bath.

8. Printed circuit **characterized in that** it contains as base material the glass fabric of claim 5 or 6.

**Patentansprüche**

1. Verfahren zum Herstellen einer Glasstruktur, bei der der Schussfaden und der Kettfaden aus einem Glasfaden aus mehreren Filamenten bestehen, wobei das Verfahren die folgenden Phasen umfasst:

- Spinnen des geschmolzenes Glases, um Glasfilamente auszubilden;
- Zusammenfassen der Glasfilamente auf eine Art und Weise, um einen kontinuierlichen Glasfaserschussfaden und Glasfaserkettfaden auszubilden;
- Aufwickeln des Fadens kontinuierlicher Glasfasern, um eine Formingplatte auszubilden;
- Verwenden der Fäden von kontinuierlichen Glasfasern, um die Glasstruktur zu weben, **dadurch gekennzeichnet, dass** der Schussfaden und/oder der Kettfaden einen abgeflachten Querschnitt aufweist und unverdreht gewoben ist und nicht erneut aufgewickelt werden muss.

2. Verfahren nach Anspruch 1, wobei nur der Schussfaden oder der Kettfaden einen abgeflachten Querschnitt aufweist und unverdreht gewoben ist und beim Herstellen der Glasstruktur nicht erneut aufgewickelt wird, während der Kettfaden oder der Schussfaden einen ungefähr runden Querschnitt aufweist und verdreht worden ist.

3. Verfahren nach Anspruch 1 oder 2, wobei die Struktur den Kettfaden und den Schussfaden umfasst, wobei die Glasfilamente wenigstens eines von diesen durch den flachen Querschnitt **gekennzeichnet** sind und wobei die Struktur ferner **dadurch gekennzeichnet ist, dass** diese aus den kontinuierlichen Glasfasern besteht, die keinen Prozess eines weiteren Verdrehens oder erneuten Aufwickelns benötigen.

4. Verfahren zum Herstellen eines Prepregs, **dadurch gekennzeichnet, dass** dieses mit einer Glasstruktur ausgebildet wird, die gemäß den Verfahren nach einem der Ansprüche 1 bis 3 erhalten wird, und in einen halbfesten Zustand durch die Imprägnierung in einem thermoflxierenden Harzbad und durch ein anschließendes Trocknen gebracht worden ist.

5. Glasstruktur, umfassend Schuss- und Kettfäden, die aus Glasfäden aus mehreren Filamenten bestehen, **dadurch gekennzeichnet, dass** der Schussfaden und/oder der Kettfaden ein flacher, unverdrehter und nicht erneut aufgewickelter Faden ist.

**6.** Glasstruktur nach Anspruch 5, wobei der Schussfaden ein flacher, unverdrehter und nicht erneut aufgewickelter Faden ist, während der Kettfaden ein ungefähr runder, verdrehter Faden ist.

**7.** Prepreg, **dadurch gekennzeichnet, dass** es durch die Imprägnierung der Glasstruktur gemäß Anspruch 5 oder 6 in einem thermofixierenden Harzbad gewonnen wird.

**8.** Leiterplatte, **dadurch gekennzeichnet, dass** dieses als Grundmaterial die Glasstruktur nach Anspruch 5 oder 6 enthält.

**Revendications**

**1.** Procédé pour la préparation d'un tissu de verre dans lequel les fils de trame et de chaîne sont constitués d'un fil de verre à multiples filaments, comprenant les phases suivantes :

- le filage du verre fondu pour former des filaments de verre ;
- l'assemblage desdits filaments de verre de façon à former un fil de trame et un fil de chaîne de fibres de verre continues ;
- le bobinage dudit fil de fibres de verre continues de façon à former un gâteau ;
- l'utilisation desdits fils de fibres de verre continues pour tisser le tissu de verre, **caractérisé en ce qu'**au moins l'un du fil de trame et du fil de chaîne a une section aplatie et est tissé non retordu sans devoir être réenroulé.

**2.** Procédé selon la revendication 1, dans lequel seul le fil de trame ou le fil de chaîne a une section aplatie et est tissé non retordu et sans être réenroulé lors de la fabrication du tissu de verre, tandis que le fil de chaîne ou le fil de trame a une section grossièrement ronde et a fait l'objet d'un retordage.

**3.** Procédé selon la revendication 1 ou 2, dans lequel ledit tissu est composé de ladite chaîne et de ladite trame, dont les filaments de verre d'au moins l'une de celles-ci sont **caractérisés par** ladite section transversale plate, et lequel tissu est de plus **caractérisé en ce qu'**il est composé desdites fibres de verre continues qui ne nécessitent pas de traitement de retordage ou de réenroulage supplémentaire.

**4.** Procédé pour la préparation d'une feuille pré-imprégnée, **caractérisé en ce qu'**elle est formée d'un tissu de verre obtenu selon les procédés de l'une quelconque des revendications 1 à 3, et est amenée dans un état semi-rigide par imprégnation dans un bain de résine thermodurcissable et par séchage ultérieur.

**5.** Tissu de verre comprenant des fils de trame et de chaîne constitués d'un fil de verre à multiples filaments, **caractérisé en ce qu'**au moins l'un du fil de trame et du fil de chaîne est un fil plat, non retordu, et non réenroulé.

**6.** Tissu de verre selon la revendication 5, dans lequel le fil de trame est un fil plat, non retordu et non réenroulé, tandis que le fil de chaîne est un fil grossièrement rond, retordu.

**7.** Feuille pré-imprégnée **caractérisée en ce qu'**elle est obtenue par l'imprégnation d'un tissu de verre selon la revendication 5 ou 6 dans un bain de résine thermodurcissable.

**8.** Circuit imprimé **caractérisé en ce qu'**il contient, en tant que matériau de base, le tissu de verre de la revendication 5 ou 6.

# Figure 1

# Figure 2

# Figure 3

20:WARP

41

42

III

III

30:WEFT

9

# Figure 4

40:GLASS FIBER FABRIC

30:WEFT
30
30
30
30

20  20  20  20  20:WARP

V ←
V ←

# Figure 5

30:WEFT    F          40

20:WARP

30

# Figure 6

# Figure 7

**Figure 8**

SHORT SIDE | LONG SIDE

# Figure 9